Europäisches Patentamt

European Patent Office

Office européen des brevets

(19)

(11) **EP 1 151 529 B1**

(12) **FASCICULE DE BREVET EUROPEEN**

(45) Date de publication et mention
de la délivrance du brevet:
**11.12.2002 Bulletin 2002/50**

(21) Numéro de dépôt: **00901718.7**

(22) Date de dépôt: **04.02.2000**

(51) Int Cl.⁷: **H03B 5/18**

(86) Numéro de dépôt international:
**PCT/FR00/00272**

(87) Numéro de publication internationale:
**WO 00/046913 (10.08.2000 Gazette 2000/32)**

(54) **OSCILLATEUR A RESONATEUR DIELECTRIQUE ACCORDABLE EN TENSION**

SPANNUNGSGESTEUERTER OSZILLATOR MIT DIELEKTRISCHEM RESONATOR

OSCILLATOR WITH DIELECTRIC RESONATOR TUNABLE IN VOLTAGE

(84) Etats contractants désignés:
**AT BE CH CY DE DK ES FI FR GB GR IE IT LI LU
MC NL PT SE**

(30) Priorité: **05.02.1999 FR 9901380**

(43) Date de publication de la demande:
**07.11.2001 Bulletin 2001/45**

(73) Titulaire: **Thales
75008 Paris (FR)**

(72) Inventeurs:
• **DUSSAUBY, Marie-Pierre
  94117 Arcueil Cedex (FR)**
• **PERIS, Daniel
  94117 Arcueil Cedex (FR)**
• **GANNE, Jean-Pierre
  94117 Arcueil Cedex (FR)**

(74) Mandataire: **Dudouit, Isabelle et al
Thales Intelectual Property
13, avenue Président Salvador Allende
94117 Arcueil Cedex (FR)**

(56) Documents cités:
**WO-A-98/00881          DE-A- 19 532 905**

• **KUCHLER G: "COAXIAL CERAMIC
  RESONATORS FOR UHF AND MICROWAVES"
  COMPONENTS,DE,SIEMENS
  AKTIENGESELLSCHAFT. MUNCHEN, vol. 24,
  no. 6, page 223-227 XP000095515 ISSN:
  0945-1137**
• **BRENDAN KELLY: "1.8 GHz Direct Frequency
  VCO With CAD Assessment" RF DESIGN, vol. 16,
  no. 2, février 1993 (1993-02), pages 29-38,
  XP000363466 Englewood,CO,US**
• **PATENT ABSTRACTS OF JAPAN vol. 6, no. 140
  (E-121) [1018], 9 octobre 1980 (1980-10-09) & JP
  57 065011 A (NIPPON DENKI K.K.), 20 avril 1982
  (1982-04-20)**
• **HENICLE E: "VCO DESIGN USING COAXIAL
  RESONATORS" RF DESIGN,US,CARDIFF
  PUBLISHING CO, ENGLEWOOD,CO, vol. 18, no.
  11, page 50,52,54-55 XP000548236 ISSN:
  0163-321X cité dans la demande**

## Description

La présente invention concerne un oscillateur à résonateur diélectrique commandable en tension.

Elle s'applique notamment à la réalisation de synthétiseurs de fréquence utilisables dans les postes radio émetteurs récepteurs travaillant en évasion de fréquence.

Les oscillateurs commandables en tension comportent classiquement un résonateur diélectrique dont la fréquence de résonance est fixe. Ce résonateur est couplé à une diode encore appelée "Varicap" dont la capacité varie en fonction d'un niveau de tension qui lui est appliqué ce qui a pour effet de modifier la fréquence d'accord de l'oscillateur de façon continue dans une bande de fréquence déterminée.

Un mode de réalisation d'un oscillateur fonctionnant suivant ce principe est notamment décrit dans un article de M Ed Hénicle ayant pour titre "VCO Design Using Coaxial Resonators " publié dans la revue Trans-Tech, Inc de Novembre 1995, ou dans l'article de G. Kuchler 'Coaxial Ceramic Resonators for UHF and Microwaves', Siemens Components, vol. 24, no. 6, dec. 89, page 223-227.

Dans ces oscillateurs l'emploi d'une diode "Varicap" présente l'inconvénient de faire chuter le coefficient de surtension du résonateur ce qui a pour conséquence une dégradation du bruit de phase.

D'autres exemples d'oscillateurs comportant un résonateur diélectrique sont connus de PATENT ABSTRACTS OF JAPAN vol. 6, no. 140 (E-121) [1018], 9 octobre 1980 & JP 57 065011 A et WO 98 00881 A.

Le but de l'invention est de réaliser un oscillateur accordable en tension sur une gamme de fréquences étendue sans dégradation du coefficient de surtension du résonateur.

A cet effet l'invention a pour objet un oscillateur commandable en tension comportant un résonateur diélectrique, couplé à une impédance de charge au travers d'un élément actif amplificateur caractérisé en ce que le résonateur diélectrique se compose d'un matériau céramique à effet ferroélectrique disposé entre deux surfaces métallisées et polarisé par un champ électrique créé par une différence de potentiel appliquée entre les deux surfaces fonction de la fréquence d'accord de l'oscillateur.

L'invention a pour avantage qu'elle permet d'appliquer une commande en tension directement sur le matériau composant le résonateur sans dégrader son coefficient de surtension. Par ce principe il devient possible de réaliser un oscillateur commandable en tension ayant une caractéristique de bruit de phase d'au moins 20 dB dans des gammes de fréquence très étendues allant des ondes UHF aux hyperfréquences ce qui ne peut être atteint avec les oscillateurs à commande à diode "Varicap" de l'art antérieur.

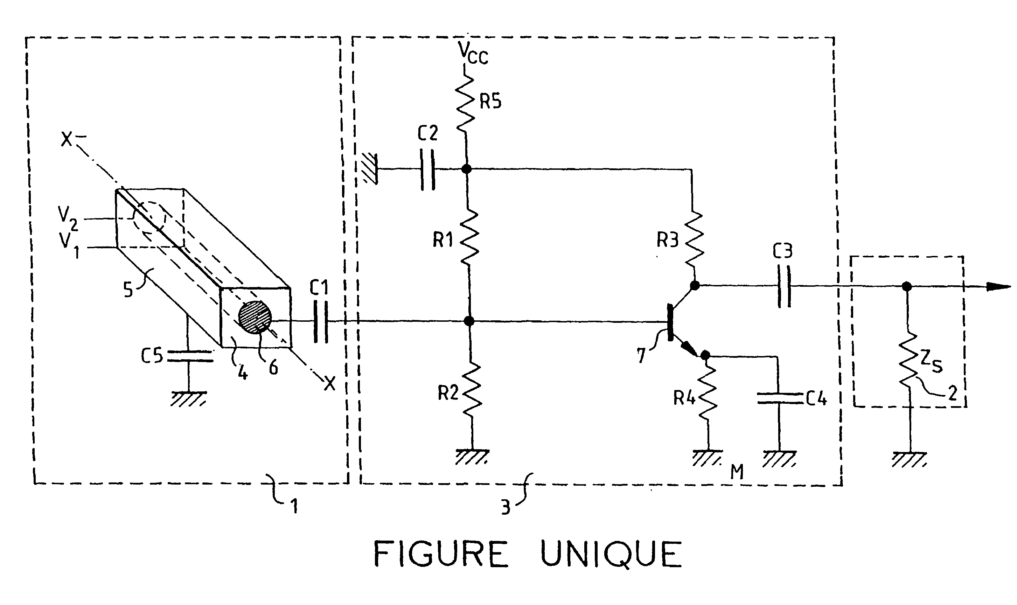

D'autres caractéristiques et avantages de l'invention apparaîtront à l'aide de la description qui suit faite en regard de la figure unique annexée qui représente un mode de réalisation d'un oscillateur commandable en tension selon l'invention.

L'oscillateur selon l'invention qui est représenté sur la figure unique comprend un résonateur 1 couplé à une charge 2 par l'intermédiaire d'un élément actif 3. Le résonateur 1 est réalisé dans un matériau céramique au barium-strontium-titane du type de ceux décrits dans l'article de MM M.LABEYRIE, F.GUERIN, TM ROBINSON et JP GANNE du centre de recherche de la société THOMSON-CSF publié en 1994 conférence IEEE antenna propagation ayant pour titre "Microwave characterisation of ferroelectric $Ba_{1-x}Sr_x Ti O_3$ ceramics".

Ces matériaux ont la propriété d'avoir des permittivités susceptibles de varier sous l'action d'un champ électrique inférieur ou égal à quelques centaines de volts par millimètre. Cette variabilité de la permittivité est d'autant plus forte que la composition du matériau est riche en baryum. De même les pertes diélectriques sont d'autant plus faibles que le matériau est riche en strotium. Le matériau mis en oeuvre dans l'invention appartient à la famille des céramiques répondant à la formule:

$$Ba_{x_i}Sr_{(1-x)}Ti_{(1-y)}(A)_y O_3 \qquad (1)$$

dans laquelle:

- A est un composant permettant de réduire les pertes diélectriques du matériau qui peut être notamment du fer, du manganèse ou encore une combinaison des deux

$$- 0{,}4 \leq x \leq 0{,}9$$

$$- 0{,}001 \leq y \leq 0{,}2$$

Ses formes et dimensions sont adaptées aux fréquences d'accord Fo de l'oscillateur souhaitées.

Sur la figure le matériau diélectrique 4 a la forme d'un barreau parallélépipèdique rectangle recouvert sur sa surface extérieure par un dépôt métallique 5. Il est traversé par un trou métallisé 6 centré selon son axe longitudinal XX'. Ainsi réalisé le résonateur se comporte comme une ligne coaxiale dont la capacité linéique varie en rapport avec la variation de la permittivité du matériau céramique 4 ce qui permet de le faire résonner sur une fréquence d'accord Fo dépendant de sa longueur et de la grandeur du champ électrique appliqué entre les surfaces métalliques dans l'épaisseur du matériau. Le résonateur peut également être réalisé sous la forme d'un barreau cylindrique, de cavité, de disque ou encore en utilisant les techniques de fabrication des circuits à microrubans encore connues sous les désignations anglo-saxonnes microstrip ou stripline.

Dans le mode de réalisation représenté la surface métallique extérieure 5 est soumise à un niveau de tension continu V1 et le trou métallisé 6 est soumis à un niveau de tension continu V2 relativement au potentiel d'un circuit de masse M. La différence de potentiel V2-V1 définit la fréquence d'accord. Cette configuration est particulièrement bien adaptée à l'emploi de l'oscillateur dans une boucle à verrouillage de phase d'un synthétiseur de fréquence. Dans ce cas la tension V1 correspond à une tension de préaccord "pas gros" et la tension V2 à celle délivrée par le comparateur de phase du synthétiseur de fréquence qui correspond à la tension de commande "pas fin".

Cependant il est également possible suivant un autre mode de réalisation de l'invention de n'utiliser qu'une seule tension de commande il suffit dans ce cas de relier directement la surface métallique 5 au circuit de masse M.

L'entretien des oscillations est assuré par l'élément actif 3 dont l'entrée couplée à une extrémité du trou métallisé 6 par l'intermédiaire d'un condensateur de liaison C1, présente une résistance négative.

L'élément actif 3 comprend un transistor 7 polarisé de façon connue entre une tension Vcc d'alimentation et le circuit de masse M par deux résistances R1, R2 montées en diviseur potentiométrique reliées par leurs extrémités communes à la base du transistor 7, une résistance de collecteur R3 et une résistance d'émetteur R4 découplée par un condensateur C4 au circuit de masse M.

La tension Vcc est appliquée sur les extrémités libres des résistances R1 et R3 par l'intermédiaire d'une résistance R5 et le point commun aux résistances R1, R3 et R5 est découplé au circuit de masse m par un condensateur C2.

La charge inductive 2 est couplée au collecteur du transistor 7 par l'intermédiaire d'un condensateur C3.

Les paramètres de bruit de l'oscillateur dépendent de la qualité de l'élément actif 3 et du coefficient de surtension du résonateur. Cette qualité est obtenue en utilisant un transistor présentant un faible bruit de phase en 1/f ainsi qu'un très bon facteur de bruit. La surtension du résonateur et sa commandabilité dépendent de la composition du matériau céramique 4 et de la qualité de la métallisation.

## Revendications

1. Oscillateur commandable en tension comportant un résonateur diélectrique (1), couplé à une impédance de charge (2) au travers d'un élément actif amplificateur (3), **caractérisé en ce que** le résonateur diélectrique (1) se compose d'un matériau céramique (4) à propriété ferroélectrique disposé entre deux surfaces métallisées (5, 6) et polarisé par un champ électrique créé par une différence de potentiel appliquée entre les deux surfaces (5, 6), laquelle différence de potentiel définit la fréquence d'accord de l'oscillateur.

2. Oscillateur selon la revendication 1, **caractérisé en ce que** le matériau céramique (4) se compose d'oxydes métalliques de la famille :

$$Ba_{x_i}Sr_{(1-x)}Ti_{(1-y)}(A)_yO_3 \qquad (1)$$

dans laquelle :

- A est un composant permettant de réduire les pertes diélectriques du matériau qui peut notamment être du fer, du manganèse ou encore une combinaison des deux

$$- 0,4 \leq x \leq 0,9$$

$$- 0,001 \leq y \leq 0,2$$

3. Oscillateur selon l'une quelconque des revendications 1 et 2, **caractérisé en ce qu'**il comprend des moyens pour appliquer entre les deux surfaces (5, 6) un champ électrique inférieur ou égal à quelques centaines de volts par millimètre.

4. Oscillateur selon l'une quelconque des revendications 1 à 3, **caractérisé en ce que** le matériau céramique (4) a la forme d'un barreau parallélépipèdique rectangle recouvert sur sa surface extérieure par un dépôt métallique (5) et est traversé par un trou métallisé 6 centré selon son axe longitudinal XX'.

5. Oscillateur selon l'une quelconque des revendications 1 à 3, **caractérisé en ce que** le matériau céramique (4) a la forme d'un barreau cylindrique recouvert sur sa surface extérieure par un dépôt métallique (5) et est traversé par un trou métallisé (6) centré selon son axe longitudinal.

6. Oscillateur selon l'une quelconque des revendications 1 à 3, **caractérisé en ce que** le résonateur (1) est réalisé sous la forme d'un circuit microruban.

7. Oscillateur selon l'une quelconque des revendications 1 à 3, **caractérisé en ce que** le matériau céramique a la forme d'un disque.

8. Utilisation de l'oscillateur selon l'une quelconque des revendications 1 à 7 à la mise en oeuvre d'un synthétiseur de fréquence.

**Claims**

1. Voltage-controlled oscillator comprising a dielectric resonator (1), coupled to a load impedance (2) through an amplifying active element (3), **characterized in that** the dielectric resonator (1) is composed of a ceramic (4) having a ferroelectric property placed between two metallized surfaces (5, 6) and biased by an electric field created by a potential difference applied between the two surfaces (5, 6), which potential difference defines the tuning frequency of the oscillator.

2. Oscillator according to Claim 1, **characterized in that** the ceramic (4) is composed of metal oxides of the family:

$$Ba_xSr_{(1-x)}Ti_{(1-y)}(A)_yO_3 \qquad (1)$$

in which:

- a is a constituent allowing the dielectric losses of the material to be reduced, which constituent may especially be iron, manganese or a combination of the two;

$$- 0.4 \leq x \leq 0.9;$$

$$- 0.001 \leq y \leq 0.2.$$

3. Oscillator according to either of Claims 1 and 2, **characterized in that** it comprises means for applying an electric field of less than or equal to a few hundred volts per millimetre between the two surfaces (5, 6).

4. Oscillator according to any one of Claims 1 to 3, **characterized in that** the ceramic (4) is in the form of a rectangular parallelepipedal bar which is covered on its external surface with a metal coating (5) and through which passes a plated-through hole (6) centred on its longitudinal axis XX'.

5. Oscillator according to any one of Claims 1 to 3, **characterized in that** the ceramic (4) is in the form of a cylindrical bar which is covered on its external surface with a metal coating (5) and through which passes a plated-through hole (6) centred on its longitudinal axis.

6. Oscillator according to any one of Claims 1 to 3, **characterized in that** the resonator (1) is made in the form of a microstrip circuit.

7. Oscillator according to any one of Claims 1 to 3, **characterized in that** the ceramic is in the form of a disc.

8. Use of the oscillator according to any one of Claims 1 to 7 for the operation of a frequency synthesizer.

**Patentansprüche**

1. Spannungssteuerbarer Oszillator mit einem dielektrischen Resonator (1), der über ein aktives Verstärkungselement (3) mit einer Lastimpedanz (2) gekoppelt ist, **dadurch gekennzeichnet, daß** der dielektrische Resonator (1) aus einem keramischen Material (4) mit ferroelektrischer Eigenschaft besteht, das zwischen zwei metallisierten Oberflächen (5, 6) angeordnet ist und durch ein elektrisches Feld polarisiert ist, das durch eine Potentialdifferenz erzeugt wird, die zwischen den zwei Oberflächen (5, 6) angelegt ist, wobei die Potentialdifferenz die Resonanzfrequenz des Oszillators definiert.

2. Oszillator nach Anspruch 1, **dadurch gekennzeichnet, daß** das keramische Material (4) aus Metalloxiden der Familie:

$$Ba_xSr_{(1-x)}Ti_{(1-y)}(A)_yO_3 \qquad (1)$$

besteht, in welcher:

- A ein Bestandteil ist, der es ermöglicht, die dielektrischen Verluste des Materials zu verringern und insbesondere aus Eisen, Mangan oder auch einer Kombination der zwei bestehen kann, wobei

$$- 0{,}4 \leq x \leq 0{,}9$$

und

$$- 0{,}001 \leq y \leq 0{,}2$$

ist.

3. Oszillator nach einem der Ansprüche 1 und 2, **dadurch gekennzeichnet, daß** er Mittel zum Anlegen eines elektrischen Feldes, das kleiner oder gleich einigen Hundert Volt pro Millimeter ist, zwischen den zwei Oberflächen (5, 6) umfaßt.

4. Oszillator nach einem der Ansprüche 1 bis 3, **dadurch gekennzeichnet, daß** das keramische Material (4) die Form eines parallelepipedischen Rechteckstabes aufweist, der auf seiner äußeren Oberfläche mit einer Metallschicht (5) bedeckt ist und von einem metallisierten Loch 6 durchquert wird, das entlang seiner Längsachse XX' zentriert ist.

5. Oszillator nach einem der Ansprüche 1 bis 3, **dadurch gekennzeichnet, daß** das keramische Material (4) die Form eines zylindrischen Rechteckstabes aufweist, der auf seiner äußeren Oberfläche mit einer Metallschicht (5) bedeckt ist und von einem metallisierten Loch 6 durchquert wird, das entlang seiner Längsachse zentriert ist.

6. Oszillator nach einem der Ansprüche 1 bis 3, **dadurch gekennzeichnet, daß** der Resonator (1) in Form einer Mikrostreifenleiter-Schaltung ausgeführt ist.

7. Oszillator nach einem der Ansprüche 1 bis 3, **dadurch gekennzeichnet, daß** das keramische Material die Form einer Scheibe aufweist.

8. Verwendung des Oszillators nach einem der Ansprüche 1 bis 7 zur Polarisierung eines Frequenzsynthesizers.

FIGURE UNIQUE